(19) Europäisches Patentamt
European Patent Office
Office européen des brevets

(11) Publication number: **0 136 812**
**A2**

(12) # EUROPEAN PATENT APPLICATION

(21) Application number: 84305829.8

(22) Date of filing: 24.08.84

(51) Int. Cl.⁴: G 01 N 24/08
A 61 B 5/05

(30) Priority: 25.08.83 US 526561
12.10.83 US 541220

(43) Date of publication of application:
10.04.85 Bulletin 85/15

(84) Designated Contracting States:
AT BE CH DE FR GB IT LI LU NL SE

(71) Applicant: TECHNICARE CORPORATION
29100 Aurora Road
Solon, Ohio 44139(US)

(72) Inventor: Yeung, Hong-Ning
4829 Lindsey Oval
Richmond Heights Ohio OH 44143(US)

(74) Representative: Colgan, Stephen James et al,
CARPMAELS & RANSFORD 43 Bloomsbury Square
London WC1A 2RA.(GB)

(54) **Reagents for enhancing the contrast in NMR images.**

(57) Reagents for enhancing the contrast of nuclear magnetic images of biological tissues. By contacting the tissues to be imaged with a complex comprising a macromolecule attached to a paramagnetic ion, wherein the macromolecule is tissue specific and the complex has a correlation time of reorientation or a correlation time of rotation of ligands comparable to the Larmor period, the target atom (proton) relaxation rates are altered and the contrast in the images produced by conventional nuclear magnetic resonance techniques is enhanced.

EP 0 136 812 A2

# REAGENTS FOR ENHANCING THE CONTRAST IN NMR IMAGES

## Field of the Invention

This invention relates to the field of nuclear magnetic resonance (NMR) imaging and in particular, provides reagents whereby the contrast in NMR images may be enhanced.

## Background of the Invention

Due to the recent trend in scientific development concerning nuclear magnetic resonance (NMR) imaging techniques, there has been an increase in awareness concerning their usefulness in the clinical environments. In particular, these techniques have been shown capable of providing unique images of internal biological structures without the concurrent risks associated with x-ray techniques including computed tomography methods, or the limitations imposed by ultrasonically related techniques.

Although the phenomenon of nuclear magnetic resonance has been known since 1946 and has been employed in the chemical laboratory as a means for studying structural as well as the dynamic aspects of molecules, it is only of late that the technique has been shown to be useful for imaging internal body structure. Indeed, the assignee hereof now has a number of NMR instruments in experimental development which have provided sharp and detailed views including 3-dimensional reconstructions of internal organs. These instruments have, to date, the capability of measuring the proton distribution of a sample material as well as the dynamic characteristics of the local region where the host molecules resides. This is accomplished by the methods of NMR imaging.

In essence, NMR deals with the interactions between a collection of nuclear magnetic moments subjected to externally applied magnetic fields. The nuclear magnetic moments result from the intrinsic angular momentum, also called spin, characteristic of atomic nuclei with an odd number of either protons or neutrons. The interaction of these nuclear magnetic moments in the presence of applied magnetic fields is, in general, complicated and follows the laws of quantum mechanics. A rudimentary description of the macroscopic behavior of the spins, manifested as experimental observables, is possible based on simple classical laws.

Consider a collection of nuclear spins immersed in a strong constant magnetic field Bo, which points along the z-axis of a Cartesian coordinate system. The motion experienced by each nuclear magnetic moment follows a rather complicated path which consists of precession about a net field which is the vector sum of the external field Bo and a local field $B_{loc}$ arising from its neighboring spins ($B_{loc}$ << Bo). The local field $B_{loc}$, due to thermal motion, is stochastic in nature and tends to fluctuate randomly. These stochastic processes provide the main mechanism for restoring thermal equilibrium, necessary to satisfy the second law of thermodynamics. The physical process which causes the spins to reach equilibrium is called relaxation. This will be discussed in greater detail later. It is important to realize, however, that individual nuclear magnetic moments cannot be experimentally observed. What is measurable in the laboratory is their statistical average over a macroscopic dimension, appropriately adjusted in accordance with the desired application. For conventional applications, this dimension is selected to encompass the entire sample. For NMR imaging, the dimension is the volume element resolved by the image.

This macroscopic quantity of nuclear magnetic moment is called magnetization. Thus, NMR signals are measures of nuclear magnetization.

At thermal equilibrium, the magnetization, Mo, is parallel to Bo and its magnitude proportional to Bo. The proportionality constant is given by the well-known van Vleck formula:

$$Mo = \chi\, Bo$$

$$\chi = N \frac{\gamma^2 \hbar^2\, I(I+1)}{3kT} \qquad (1)$$

where the symbols are defined as follows:

$\chi$ = magnetic susceptibility
$\gamma$ = nuclear gyromagnetic ratio = $\mu/I$;
$\mu$ = nuclear magnetic moment
$\hbar$ = $h/2\pi$, where h is the Planck constant
I = spin quantum number (for proton I = 1/2)
k = Boltzman constant
T = temperature in Kelvin
N = number of nuclei.

It is clear from (1) that the sensitivity of the NMR signal increases as field strength increases and as temperature decreases. Equation (1) also shows that nuclei which have a large gyromagnetic ratio, also provide greater signal sensitivity. Among all the nuclei known in the periodic table, the proton has the second largest gyromagnetic ratio (second only to tritium, another isotope of hydrogen which is rare in natural abundance). For this reason, protons are the most commonly studied nuclei in NMR. Other important nuclei of biological interests include, in decreasing order of sensitivity, $^{19}F$, $^{23}Na$, $^{31}P$, $^{13}C$ and $^{17}O$. Due to the limited quantity of fluorine compound in animal tissues, however, doubts

have been cast upon the importance of $^{19}F$ resonance in conventional biological applications.

After application of an excitation radiofrequency magnetic field $B_1$ which is pendicular to the static magnetic field Bo, the magnetization of the affected nuclei will deviate about the z-axis in a motion which may be described as similar to that of a spinning top. The nuclei will spin about the z-axis at an angular frequency called the Larmor frequency.

This rate of angular or precession about Bo is directly proportional to the magnetic field strength, $\omega_0 = \gamma Bo$. However, so long as the magnetization remains parallel to Bo, there will be no macroscopic precession and as a result no electrical signal impressed upon the receiver coil. In order to derive NMR information, it therefore becomes necessary to apply an external, time dependent magnetic field, directed orthogonally to the axis of Bo, the static magnetic field. Such a field is typically applied by the use of radio frequencies and is further applied at or close to the frequency of precession (Larmor frequency) in order to resonate with the nuclear spin system and hence drive the magnetization away from equilibrium. The RF field is turned on for a length of time sufficient to direct the bulk magnetization vector to an angle of, typically, 90° from the static field direction Bo. As a result, the bulk magnetization of nuclear fields precesses about Bo (the static field) in the transverse plane at the Larmor frequency. Detection of the magnetization of the nuclei as its transverse component relaxes back to equilibrium following an RF pulse, i.e. decays to zero, is termed a free induction decay.

When nuclear magnetic magnetization is brought to a state away from thermal equilibrium, for example by turning on a RF pulse of certain time duration or by adiabatic demagnetization (rapidly lower the applied field strength) or by adiabatic passage (sweeping the magnetic field, in the presence of a RF field, through resonance), the magnetization will tend to return to equilibrium, through thermal motion. The motion characteristics of the process that are responsible for the equilibrium restoration of the longitudinal component of this magnetization are not identical to but are similar to those responsible for returning the transverse component to its equilibrium. As a result, the characteristic time constant associated with the longitudinal and transverse relaxation processes are not necessarily identical in value. In general, the time constant for the longitudinal relaxation, or thermal-lattice relaxation time, $T_1$, is at least as large as the decay constant for the transverse component, i.e. the spin-spin relaxation $T_2$.

The reason why $T_1 \gtrsim T_2$ arises from the fact that physically, the $T_1$ processes restore the equilibrium by dissipating excess energy from the spin system to the thermal reservoir while the $T_2$ processes merely destroy all phase coherence in the transverse plane without causing energy transition. In thermodynamic terms, the restoration of equilibrium is accomplished by minimizing the spin system energy through $T_1$ relaxation, and maximizing the system entropy (randomness) through $T_2$ relaxation. It should then be intuitively clear that any physical process which causes $T_1$ relaxation (energy transition), will also cause $T_2$ relaxation while the converse is not necessarily true. The effectiveness of these relaxation processes depends upon the strength as well as the motional characteristics of the fluctuating local fields $B_{loc}$ experienced by the nuclear spins

as intimated earlier. The magnitude of $B_{loc}$ depends usually upon the type of interaction and its associated molecular parameters. For instance, protons have a spin quantum number equal to 1/2 and thus the dominant interaction is dipole-dipole in nature. Accordingly, the strength of the local field $B_{loc}$ depends upon the magnetic dipole moment with which the proton is coupled, as well as distance between dipole moments. If the adjacent magnetic dipole is another proton, the local field the proton experiences will be much less than would be the case when the interacting dipole is an unpaired electron. This results because the electronic magnetic moment is 658 times stronger than its proton counterpart. Furthermore, the shorter the distance between interacting nuclei, the stronger will be the local field. For nuclei like deuterons which have a spin equal to or greater than 1, the dominant interaction becomes the coupling between the quadrapole moment of nuclear spin and the electric field gradient at the nucleus. The strength of $B_{loc}$, however, only accounts for half of the relaxation phenomena. The other half comprises the molecular motions which cause $B_{loc}$ to change stochastically. The physical reason underlying the motional characteristics of $B_{loc}$ is important in determining $T_1$ and $T_2$ and can be illustrated by the dipole-dipole interaction.

In the presence of a strong static field Bo, the individual spin magnetic moments do not precess independently at the Larmor frequency $\omega_0$ but rather, the coupled system is described by a set of complicated normal modes of precession having a quasi-continuous distribution of frequencies within the neighborhood of $\omega_0$ and distributed over a frequency range of $\gamma B_{loc}$. To exploit the explanatory advantages provided by the local field concept, observations may be advantageously made

from the vantage point of one of the nuclear spins rotating about the z-axis (coordinate system) at a frequency $\omega_0$ in the same sense as the Larmor precession. In this coordinate system (generally known as the rotating frame), the spins do not appear to precess under the influence of Bo because, in this frame of reference a fictitious field, equal and opposite to Bo, is generated thereby effectively cancelling Bo. Consequently, only the local fields remain to act upon the spins. These local fields in the rotating frame can be separated into a stationary part and a part which oscillates with zero mean at frequencies $\omega_0$ and $2\omega_0$. These three frequency components of the local fields establish the link connecting the spin system to thermal motion.

To describe the stochastic nature of molecular motions, it is advantageous to define a time auto-correlation function G(t) of the local fields $B_{loc}$, a physical quantity:

$$G(t) = \langle B_{loc}(0)\ B_{loc}(t)\rangle \qquad (2)$$

where < > represents the ensemble average over the whole system. For most physical processes, G(t) is at least approximately exponential and thus:

$$G(t) = \langle B^2{}_{loc}\rangle \quad e^{-t/\tau_c} \qquad (3)$$

where $\langle B^2{}_{loc}\rangle$ is the strength of the local field discussed earlier and the time constant $\tau_c$ is the correlation time which can be loosely defined as the time duration at which the fluctuating $B_{loc}(t)$ still retains part of its previous history. The frequency spectrum of the fluctuating local field is then, according to the Wiener-Khintchine theorem, the Fourier transform of the auto-correlation function G(t):

$$J(\omega) = \int_{\infty}^{\infty} G(t)e^{-i\omega t}\, dt \qquad (4)$$

As intimated earlier, one needs only to analyze the frequency components of $J(\omega)$ around the frequencies 0, $\omega_0$ and $2\omega_0$ since these are the only frequency components that are important in relaxation. At $\omega = o$, the local fields $B_{loc}$ appear static. Their effect is simply to produce a loss of any original phase relationship between the nuclear spin in question and its neighboring spins. i.e. they appear to precess with respect to one another at a frequency of the order of that of $B_{loc}$. As a result, J(0) can only cause transverse relaxation. The frequency components, $\omega_0$ and $2\omega_0$, do not cause any cumulative dephasing of the nuclear spin but produce oscillatory perturbation of small amplitude at the Larmor frequencies and its second harmonics. Thus, their effect is analogous to applying RF fields at the Larmor and at twice the Larmor frequencies which in essence causes transition between spin energy levels. As a consequence, $J(\omega_0)$ causes spin-lattice relaxation and thus also spin-spin relaxation.

To assist in this understanding, reference to FIG. 1 may be helpful where a schematic plot of $T_1$ and $T_2$ as a function of correlation time spanned through the inverse of all relevant frequencies is shown. $T_1$ is typically thought of varying from milliseconds in liquids to months in solids with biological tissues exhibiting a $T_1$ constant within the range of approximately 0.10 to 3 seconds for $^1H$.

In order to obtain spatially related information from the NMR signal, however, spatial information must be initially encoded into the NMR signal. This is accomplished by spacially varying the strength of the externally supplied Bo magnetic field, typically in a linear fashion.

Thus, the Larmor frequency, will be proportional to the field Bo and will also vary with position. Accordingly, the frequency spectrum, obtained by mathematical manipulation, provides an NMR signal distribution along a single axis and by revolving the gradient magnetic field multiple NMR frequency spectra, corresponding to different projections of the object, may be obtained. NMR images can be formed by using a filtered back-projection reconstruction algorithm on the NMR signals similar to the methods being practiced in x-ray computed tomography. Another method which is becoming increasingly popular in NMR imaging is the Fourier Zeugmatography method proposed by Ernst et al. ("NMR Fourier Zeugmatography", A. Kumar, D. Welti, and R. Ernst, J. Mag Resonance, 18, 69-83 (1975) ). This method essentially uses frequency to encode information along one dimension by recording the NMR signal in the presence of a magnetic gradient field along that direction. In addition, to encode spatial information in a second direction, orthogonal to the first, a gradient magnetic field in that second direction is successively applied, in pulsatile form, for a short duration after the magnetization is brought to the transverse plane but prior to recording the NMR data. A multitude of data lines may thus be obtained, each of which carries phase-encoded information corresponding to a Fourier component of the position coordinate along the direction whose spatial information is sought. By performing a 2-dimensional Fourier transformation, one with respect to time and the other with respect to the phase-encoding gradient amplitude, a 2-dimensional image is obtained.

Additional description concerning the basic physics underlying NMR imaging may be obtained by reference to an article by Hinshaw and Lent in Proceedings of IEEE, Vol. 71, 3:338-350 (1983) entitled "An Introduction to NMR

Imaging: From the Bloch Equation to the Imaging Equation" or to an article in the May 1982 issue of Scientific American by I. Pykett entitled "NMR Imaging in Medicine".

Generally, signal intensity of an NMR image depends upon the number of proton nuclei per unit volume. Since proton distribution in tissue is approximately uniform, the variation in $T_1$ and $T_2$ relaxation times within the different tissues provides the key contrast mechanism for anatomical discrimination. The contrast between different tissues is a reflection of differing relaxation rates, in turn reflective of the different environments surrounding the hydrogen nuclei. Although for the most part the contrast in NMR images provides sufficient information for ready discrimination between tissues, including the identification of many normal and abnormal tissues, it has often been determined desirable to enhance the contrast particularly between otherwise very similar tissues. It is accordingly an objective of the present invention to provide reagents whereby such contrast enhancement may be obtained.

In a development related to the early uses of NMR techniques, that of differentiating and distinguishing chemical structures, nuclear magnetic resonance has been employed as a tool to derive the structure and function of enzymes. In particular, and due to its presence within many enzyme molecules, the paramagnetic probe, manganese ion ($Mn^{++}$) has been used to study the effects of modulating the equilibrium between closely related states of proteins as well as the nuclear relaxation rates of water protons, the nuclear relaxation rates of closely associated nuclei, and the ESR and NMR in the presence of both manganese and a different paramagnetic probe such as chromium or other spin label. These uses have been recently reviewed in an article by Niccolai et al.,

entitled "Manganese II as Magnetic Relaxation Probe in the Study of Biomechanisms and of Biomacromolecules", Chem. Rev. 82:359-384 (1982).

Additional detail with respect to the interactions of paramagnetic metals and enzymes may be had by reference to a book by R. Dwek entitled "Nuclear Magnetic Resonance in Biochemistry" printed by Clarendon Press Oxford, copyright 1975, and in particular, with specific reference to Chapters 10 and 11. Still additional studies reporting the structure and activity of PEP carboxykinase, PEP carboxylase and pyruvate kinase have been reported by Mildvan et al., "Applications of Nuclear Relaxation to Macromolecular Systems" in Advanced Enzymology 33:26-70 (1970).

Much of the work cited in the above publications rests in part upon the theoretical foundations provided by N. Bloembergen in his early work describing proton relaxation times in various paramagnetic solutions. In particular, Bloembergen describes the formation of the water octahedron about manganese ions and specifically explains some of the mechanisms relating to the modulation of the crystalline field splitting, the g-tensor, and the hyperfine coupling by Brownian motion upon the relaxation times. This work has been reported in the Journal of Chemical Physics, Vol. 34, No. 3:842-850 (1961) and in the Journal of Chemical Physics, Vol. 27, 2:572-573 (1957).

Based in part upon Bloembergen's work, it was recognized that manganese, with its unpaired electron, has approximately a 700 times stronger magnetic moment than that of $^{1}H$. Accordingly, and due to the formation of a manganese octahedral complex with water molecules which undergoes rapid exchange with the surrounding bulk water, the hydrogens relax much faster in the presence of

manganese and thus, dependent upon the $Mn^{++}$ concentration, proton NMR signal recovers rapidly as a result of a shorter $T_1$. The signal, however, also decays rapidly due to a shorter $T_2$. This effect is attributable, at least in part, to $Mn^{++}$'s abnormally high ratio of $T_1/T_2$, a characteristic unlike most other paramagnetic ions of transition metals.

Based on this effect of manganese ion as a water relaxation agent, Lauterbur et al., chose manganese as a paramagnetic ion for an <u>in vivo</u> study of relaxation rates. See "Augmentation of Tissue Water Proton Spin-Lattice Relaxation Rates by <u>In Vivo</u> Addition of Paramagnetic Ions" in Frontiers of Biological Energetics, Vol. 1:752-759 (1978). It was hoped that the injection of the manganese ion would affect the relaxation rates between normal and infarcted or ischemic myocardium. Lauterbur reported that he was able to delineate the ischemic region of a dog heart after injection of a solution containing manganese ion.

It is, however, widely recognized that the effects produced by a solution of manganese ion are disappointing as the reorientation of the manganese complex occurs too rapidly to substantially affect the relaxation rates of protons which are coordinately bonded to the manganese ion. Thus, with the use of reasonably dilute $Mn^{++}$ solution the $T_1$ of the protons in tissue is not significantly changed and little contrast enhancement is accomplished. Further, it should be noted that manganese ion solutions are, by their very nature, toxic unless extreme dilutions (<10 μM) are used, thus limiting their human <u>in vivo</u> applications.

It is an object of the present invention to provide reagents which significantly enhance the proton relaxation effectiveness of manganese ion.

It is a further object of the present invention to provide reagents which reduce the toxicity level of manganese to a safer level to permit greater in vivo applicability.

Due in large part to the work reported by Kohler and Milstein in 1975 (Nature, 256: 495-497) describing methods for producing a continuous cell line capable of making homogeneous antibody, i.e. the so-called monoclonal antibodies, from hybridoma cells, dramatic advances are being made in the areas of immunology and the differentiation between tissues based on characteristic antigenic determinants. This has been made possible because monoclonal antibodies, may be obtained with narrowly defined specificities, i.e. the antibodies only react with the antigens for which they are specific. Thus, by employing any one of a variety of well-known immunoassay techniques, tissues and cells may be differentiated based on the presence or absence of various surface antigens or intracellular antigens. Numerous applications of such specifically reacting molecules therefore suggest themselves and include the diagnosis of various forms of cancer, infectious disease processes, as well as therapies therefor. Typically, labels are attached to the antibodies to assist in their detection and thus provide diagnosis. Similarly, therapy may be accomplished by attaching chemotherapeutic or radiotherapeutic agents.

Although there are often great difficulties associated with obtaining an antibody having the desired specificity vis-a-vis specified tissue types, once obtained, the antibodies may be employed in a variety of imaging techniques. To date, these have uniformly been limited to

enzyme linked immunoassay systems, fluorescence analysis, such as by the so-called flow cytometric systems, as well as by radiographic methods. Indeed, several articles report at least limited success with respect to such methods and include: Wolf et al., "Use of Radiolabeled Antibodies For Localization of Neoplasms", Arch. Intern. Med., Vol. 141:1067-1070 (1981); Eckelman et al., "Radiolabeling of Antibodies", Cancer Research, Vol. 40:3036-3042 (1980); Khaw et al., "Myocardial Infarct Imaging of Antibodies to Canine Cardiac Myocin With Indium-111 Diethylenetriamenepentaacedic Acid", Science, Vol. 209:295-297 (1980); and Goldenberg et al., "Use of Radiolabeled Antibodies to Carcinoembryonic Antigen for the Detection and Localization of Diverse Cancers by External Photoscanning", New England Journal of Medicine, 298, 25:1384-1388 (1978).

All of the above radioscanning methods rely upon the employment of radioisotopes as tracers or labels and thus incur a spectrum of related risks regarding the handling, production, and disposal difficulties associated therewith.

It is an object of the present invention to avoid such radioisotope related risks and to employ nonradioisotopic labels which may be safely handled.

It is another object of the present inventions to provide reagents for enhancing NMR images which may capitalize on the target specificity associated with antibodies.

As a related aspect, there are a number of published procedures for attaching antibodies to a variety of labeling materials and include an article by Hnatowich et al., entitled "Radioactive Labeling of Antibody: A Simple and Efficient Method", Science, Vol. 220:613-615 (1983);

and Scheinberg et al., "Tumor Imaging With Radioactive Metal Chelates Conjugated to Monoclonal Antibodies", Science, Vol. 215:1511-1513 (1982).

It is an object of the present invention to provide reagents for NMR image enhancement which can utilize at least in part, well-known chelating attachment processes such as those cited above.

It is another object of the present invention to provide reagents which generally enhance the constrast in NMR images and in particular, NMR enhance the contrast between different specified tissue types.

It is a related object to provide reagents to enhance the contrast in NMR images of viable and nonviable tissues.

It is a yet further object to provide reagents for enhancing the contrast in NMR images between normal and cancerous or infected tissues.

It is a still further related object to avoid the toxicity problems associated with paramagnetic ions in free solution including $Mn^{++}$, by providing reagents which employ paramagnetic ions in reduced concentrations while still obtaining NMR image contrast enhancement.

Summary of the Invention

In accordance with the present invention, there is provided a reagent for altering the nuclear magnetic resonance relaxation rate of a target atom associated with a specific tissue comprising a paramagnetic ion attached to a macromolecule selected in accordance with its ability, based on molecular weight, to cause the correlation time of the paramagnetic ion to be within an order of magnitude of the Larmor period of the target atom. The reagent may be used for enhancing the contrast in NMR images otherwise obtained pursuant to well-known NMR imaging techniques by treating the tissues to be imaged with the reagent.

The macromolecule is one having a molecular weight which is selected so that, due to its attachment to the paramagnetic ion, the paramagnetic ion may be characterized by a correlation time of reorientation motion comparable to the Lamor period of the molecule whose nuclear magnetic resonance is being measured. Comparable as used in this application means within a factor of approximately 10. The macromolecule is preferably tissue specific or viability specific, and advantageously is selected from antibodies or parts thereof specific for particular tissues or antigenic sites, liposomes, enzymes, enzyme substrates, DNA, DNA probes, ATP, cell membrane components or molecules reactive therewith, cellular organelle components or other biologically compatible moelcule. Preferably, the paramagnetic ion is a transition metal ion having partially filled 3d or 4d orbitals. Advantageously, the metal is manganese, gadolinium, chromium, iron or copper. Most preferably the metal is manganese.

In a preferred embodiment, the macromolecule will be the F(ab)[1] portion of an antibody which, through a linking means, will be coupled to manganese so that the $T_1$ relaxation rates of imaged $^1H$ in tissues for which the F(ab)[1] is specific may be altered thereby enhancing the contrast in the representative NMR image.

## Brief Description of the Drawings

Further understanding of the invention may be had by reference to the drawings wherein:

FIG. 1 graphically depicts the relationship between relaxation times of protons as a function of correlation time.

FIG.2 graphically depicts a relationship between the relaxation rates and the concentration of $Mn^{++}$;

FIG.3 depicts the NMR spin-echo signal intensity using a typical repetitive pulse sequence as a function of echo timing for nuclei with different $T_1$ and $T_2$;

FIG. 4 graphically depicts a typical radio-frequency pulse sequence in NMR imagining; and

FIG. 5 graphically illustrates a theoretical estimation showing expected effectiveness of various macromolecule molecular weights.

Detailed Description of the Invention and Best Mode

To understand the theory and operation underlying the present invention, it is useful to review the effects of correlation time of molecular motions upon the relaxation times with reference to FIG. 1. In the region where $\tau_c$ is short in comparison with the Larmor frequency, the so-called extreme-narrowing limit, the power spectrum of the local field $B_{loc}$ is virtually white. It can be shown that at this limit, all spectral components (J(o), $J(\omega_o)$ and $J(2\omega_o)$ make small but approximately equal contributions to $T_1^{-1}$ and $T_2^{-1}$ so that $T_1 = T_2$. This is conventionally recognized for all simple fluids. As $\tau_c$ becomes longer, J(o), $J(\omega_o)$ and $J(2\omega_o)$ increase and thus $T_1$ and $T_2$ become shorter. At $\tau_c^{-1} \sim \omega_o/2\pi$, $J(\omega_o)$ reaches a maximum and $T_1$ reaches the minimum. As $\tau_c$ gets longer compared to the Larmor period, J(o) becomes larger while $J(\omega_o)$ and $J(2\omega_o)$ decrease thus making $T_1$ increasingly long while $T_2$ continues to decrease. This region is generally descriptive of tissue protons. Thus, $T_1$ is generally greater than $T_2$ in tissue. Finally, as $\tau_c$ becomes longer than $(\gamma B_{loc})^{-1}$, the situation associated with solids, the NMR signal is totally dipolar broadened (with line-widths in the order of tens of KHz) and $T_2$ falls within the order of microseconds.

In a weak to moderately concentrated solution of paramagnetic ions ($10^{-6}$ up to $10^{-2}$M), the relationship between $\tau_c$, $T_1$ and $T_2$ as depicted in Figure 1 is still generally applicable. The details are, however, greatly modified by the presence of the paramagnetic ions for two reasons. The explanation is expediently begun with the

molecular processes that cause the relaxations. In aqueous solutions, the manganese ion exists as an octahedral complex with six water ligands equally spaced in the coordination sphere. Assuming for the moment that all six of these ligands in the octahedral complex are water molecules, then there are two types of protons in the solution, namely, the ligand protons and the protons of the surrounding bulk water. The actual identity of these two types of proton is not permanent as they undergo rapid chemical exchange. If this exchange rate is much faster than the relaxation rate, as is the case for almost all the paramagnetic ions, then the proton relaxation rates (both $T_1$ and $T_2$) of the solution may be characterized by a single component exponential curve with a time constant $T_1$ or $T_2$. The relaxation rates $T_1^{-1}$ and $T_2^{-1}$ are then simply the weighted average of those of the two individual components; i.e.,

$$T_{2,2}^{-1} = f_M T_{1,2M}^{-1} + f_B T_{1,2B}^{-1} \qquad (5)$$

$$f_M + f_B = 1$$

where $f_B$ equals the fraction of protons in bulk water, $f_M$ equals the fraction of protons in the hydrated complex, $T_{1,2B}^{-1}$ equals the relaxation rate of protons in bulk water, and $T_{1,2M}^{-1}$ equals the relaxation rate of proton in the hydrated complex. For the dilute solutions under discussion, $f_M << f_B$ and by theoretical estimates, $T_{1,2M}$ will be on the order of $10^{-5}$ sec while $T_{1,2B}$ is in the order seconds. (For nonpure aqueous solutions, i.e. when one of the ligands is a macromolecule, $T_{1,2M}$ will be two to three orders of magnitude lower as later discussed.) For paramagnetic ion concentrations of at least $10^{-4}M$ or higher, the first term in Equation (5), i.e., the proton relaxation contributed by the ligand protons in the complex ion, is the dominant term.

As intimated earlier, the relaxation mechanism of protons in bulk water is the nuclear dipole-dipole interaction. Because the correlation time of molecular tumbling for water is $10^{-12}$ sec at room temperature and falls into the extreme narrowing limit of Figure 1, $T_{1B}$ and $T_{2B}$ can be estimated to be approximately 3 seconds. The relaxation of protons within the coordinate sphere of the paramagnetic ion complex are essentially hyperfine since the nuclear spin is 700 times weaker than the electron spin. As commonly understood, hyperfine means any interactions between the electron spin and the nuclear spins.

Thus, between the electron spin and the ligand protons (those in the coordination sphere) two major relaxation mechanisms may be identified which contribute to the relaxation rate of protons. The first is the hyperfine dipole-dipole interactions where the dipolar correlation time $\tau_r$ is determined by the internal rotation of ligand molecules. The second, or scalar interaction, also called the exchange interaction, is a quantum mechanical exchange coupling between the electron spin and the nuclear spin.

As intimated earlier, with paramagnetic ions in aqueous solution, these two mechanisms assist in explaining the relationship between the relaxation times and correlation time as depicted in Figure 1. As may be perceived, the dominant mechanism is no longer the nuclear dipole-dipole interaction but rather the hyperfine dipole-dipole and electron nuclear exchange interaction. Consequently, the motions, the correlation times of which determine $T_1$ and $T_2$, are not the same as those that determine the relaxation of the bulk water. For $T_{1B}$ and $T_{2B}$, $\tau_C$ is simply the mean period of molecular tumbling.

In the case of $T_{1M}$ and $T_{2M}$, there are three correlation times associated with the three physical processes which significantly affect the relaxation of the ligand protons. They are: $\tau_r$, the correlation time of the internal rotation of the ligand molecule around the coordination bond; $\tau_s$, the spin-lattice relaxation time of the electron; and $\tau_h$, the residence time of the proton in the ligands. The rate determining process of each mechanism is the one, among all participating processes, with the shortest correlation time. Thus, denoting the correlation time for the hyperfine dipolar interaction as $\tau_D$ and the electron-nucleus exchange interaction as $\tau_e$, the following obtains:

$$\tau_D^{-1} = \tau_r^{-1} + \tau_h^{-1} + \tau_s^{-1} \qquad (6)$$

$$\tau_e = \tau_s^{-1} + \tau_h^{-1}$$

For $Mn^{++}$ at room temperature, it has been found that $\tau_h > \tau_s$ where $\tau_s \sim 3 \times 10^{-9}$ sec. In pure aqueous solution, $\tau_r \sim 10^{-11}$ sec which is much shorter than $\tau_s$ and $\tau_h$. When a macromolecule is introduced as one of the ligands, however, $\tau_r$ can become longer than $\tau_s$ effectively ending its role as the rate determining time scale. Further, the important frequency components of the local fields for the ligand proton are, due to presence of electron spin, also modified to be 0, $\omega_o$, and $\omega_s - \omega_o$ where $\omega_s$ is the electron Larmor precession frequency. Finally, if a schematic plot like Figure 1 is carried out for the case of a paramagnetic ion system and the correlation time is allowed to vary to $\omega_r$ (presumably due to variation of ligands), the kind of $T_1$ minimum 10 shown on Figure 1 may not exist. The reason is that for such a minimum to occur, the correlation time must be one which governs the relaxation but at the same

time satisfies the condition $\omega_0 \tau_e \sim 1$. From Equation (6), $\tau_r$ is rate determining as long as $\tau_r < \tau_s$. For $Mn^{++}$, however, $\tau_s \sim 3 \times 10^{-9}$ sec, and as a result, one would expect a $T_1$ minimum to only occur in a $T_1$ plot against $\tau_r$ at the proton Larmor frequencies, i.e., about $1/2\pi\tau_s \sim 53$ MHz. For proton resonance frequencies below this threshold, there will be no minimum, since as $\tau_r$ becomes longer $\tau_s$ begins to take over as the rate determining correlation time.

Because the water molecules are weak ligands, the $Mn(H_2O)_6^{++}$ coordination complex exhibits a high spin with s = 5/2. If, however, $Mn^{++}$ are bonded to other ligands with a stronger crystal field such as amino groups within proteins, then the complex may shift to a low spin such as s = 1/2. In that instance, $T_1$ and $T_2$ will become longer, however, the $T_2/T_1$ ratio will not be significantly altered since both $T_1^{-1}$ and $T_2^{-1}$ are proportional to the factor s(s +1). To measure this effectiveness of paramagnetic complex in relaxation enhancement, a quantity called "relaxivity" is employed. Relaxivity is commonly defined as the change in relaxation rate per unit concentration increment in paramagnetic ion.

Figure 2 represents the schematic relationship of $Mn^{++}$ concentration to $T_1$ relaxation rates. With $Mn^{++}$ in a simple oct hedral water coordination sphere, curve 22 applies while curve 21 is representative of the expected relationship when $Mn^{++}$ is present in a complex including an attached macromolecule. The steepness of the slope essentially indicates the effectiveness of the complex wherein the greater the slope, the more effectively the complex alters the proton $T_1$ relaxation rates. Because of the toxicity problems associated with $Mn^{++}$, one would naturally prefer lower concentrations whenever possible.

Signal intensity in NMR imaging generally depends upon three parameters, if one ignores the effect of body motions, blood flow and diffusion. They are the local mobile proton density, $T_1$ and $T_2$. For most tissue, the mobile proton density is fairly uniform leaving $T_1$ and $T_2$ as the main parameters which determine the signal contrast. One of the most commonly used pulse sequencing methods in NMR imaging is the so-called saturation recovery sequence. Such a sequence is shown in Figures 4a, 4b, and 4c. In essence, the longitudinal magnetization is repeatedly monitored by applying a "read" event. With specific reference to Figure 4b, this "read" event can be a simple 90° pulse following which the ensuing free induced decay (FID) is recorded, or, it can be a 90°-$\tau$-180°-$\tau$ pulse pair as shown in Figure 4c, where $\tau$ is the pulse spacing, which generates a spin echo. In this latter case, it is the echo data which will be used in image formation.

The recovery time $t_R$ between read events, see Figure 4a, if judiciously chosen, can be used to produce contrast between tissues with different $T_1$'s. Immediately after the read event, the longitudinal magnetization is, for all practical purposes, zero. For the time duration, $t_R$, the z-magnetization of the protons in each tissue region recovers at a rate dictated by its characteristic $T_1$. Thus, tissues with a long $T_1$ will have considerably fewer longitudinal components to be read compared to those with a short $T_1$.

If spin-echo data is instead used to supply the image data, then the tissue contrast can be obtained using $T_2$ rather than $T_1$. This may be accomplished by setting $t_R$ long in comparison to all tissue $T_1$'s. Then the echo signal strength depends only upon the pulse spacing $\tau$ and $T_2$, and is proportional to the exponential $e^{-2\tau}/T_2$. In

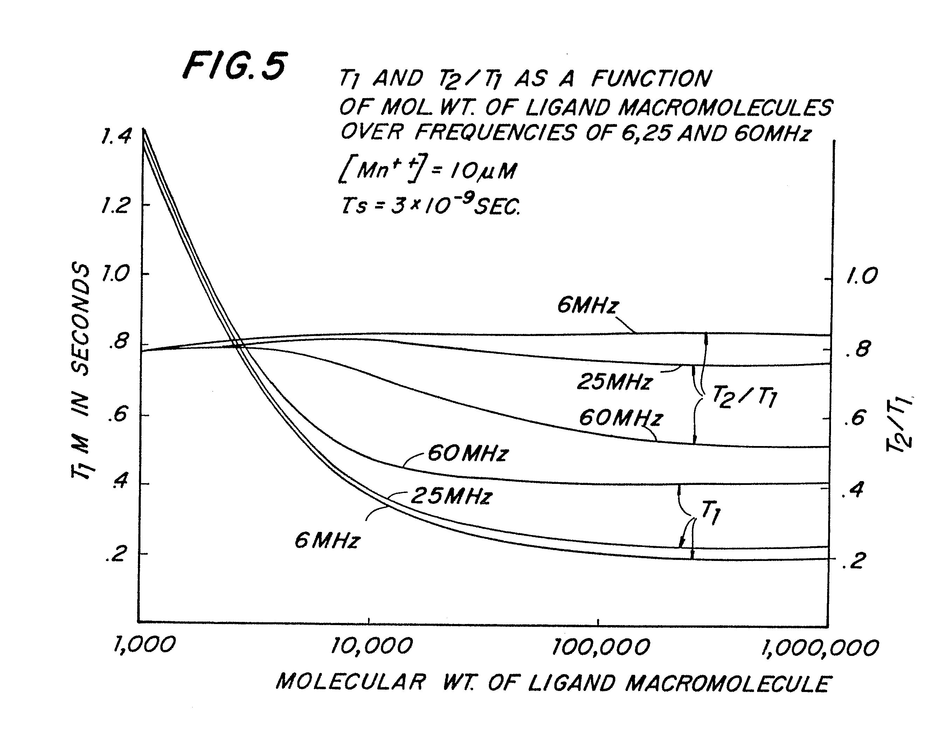

most imaging experiments, however, reasonable patient tolerance dictates a limit to the imaging time. Thus, satisfying the condition $t_r >> T_1$'s, is not always possible. Under those circumstances and as shown in Figure 5, $T_1$ and $T_2$ can exhibit contrast cross-over thereby masking tissue differences. Specifically, Figure 5 provides two examples of transverse magnetization decays with two sets of $T_1$ and $T_2$: Curve A shows $T_1$ = .45 sec and $T_2$ = .1 sec while Curve C shows $T_1$ = 1.5 sec and $T_2$ = .80 sec for $t_R$ = 1.0 sec. Curves B and D show the same relationships as A and C respectively but with a $t_R$ = 0.5 sec. It is shown that by using two recovery times $t_R$ of 0.5 sec and 1 sec, the NMR signals of one tissue type, shown by curves A and B, cross-over the NMR signal of a different tissue, shown by Curves C and D, at some point after the 90° pulse. If the cross-over point is, by happenstance, chosen to form the spin-echo, the two different tissues would become indistinguishable. This example vividly illustrates the important dependence of signal constrast upon $T_1$ and $T_2$. Thus, signal strength increases as the ratio of $T_2/T_1$ increases. Equally important, $T_1$ is ideally made short so that a short $t_R$ can be used without causing the undesirable contrast cross-over phenomena.

As has been previously noted, the short correlation times of the hydrated $Mn^{++}$ complex without the presence of macromolecules makes $Mn^{++}$ less effective in relaxing proton spins. Another disadvantage encountered with the introduction of $Mn^{++}$ hydrated complex into a biological system is the exchange reaction with magnesium (or calcium) in the tissues. Such an exchange would be governed by the following equilibrium:

$$\text{Mg-(tissue)} + Mn^{++} \underset{K}{\rightleftharpoons} \text{Mn-(tissue)} + Mg^{++}$$

Thus, the exchange of $Mn^{++}$ with $Mg^{++}$ in tissues is regulated by the thermodynamic equilibrium constant, K, and hence, exchange only takes place if it is thermodynamically or kinetically favored. Further, the introduction of $Mn^{++}$ as a hydration complex within biological samples has associated therewith a number of significant toxicity problems. These problems are collectively avoided by the reagents of the present invention while still taking advantage of the proton relaxation effects provided by $Mn^{++}$.

Specifically, and in accordance with the objects of the present invention, these problems are avoided by attaching the $Mn^{++}$ to a macromolecule. This macromolecule is chosen so that it, in effect, "slows down" the $Mn^{++}$ reorientation rates within an order of magnitude of the Larmor period of the target atom being measured. Such a macromolecule will thus have a preferred size range, and an aspect discussed at greater length later with reference to Fig. 5. Although in almost all cases the resonance of the nucleus being measured will be that of the hydrogen proton, it is equally contemplated that the present invention may be employed to alter the relaxation rate constants associated with other nuclei.

The introduction of a nonspecific macromolecule-$Mn^{++}$ hydrated complex will, however, result only in an image having uniformly greater intensity but no increase in contrast between tissues. Although in certain circumstances this effect may be beneficial, the macromolecule is preferably chosen to provide greater utility. Specifically, the macromolecule will ideally possess tissue specificity such as that associated with antibodies, particularly as exhibited by monoclonal antibodies. Thus, the $Mn^{++}$ hydrated complex, through the specificity provided by the antibody, attaches only to

those tissues having the antigenic reaction sites for which the antibody is specific. Thus, the $Mn^{++}$ macromolecule complex will be associated only with those tissues possessing the requisite antigenic sites to the substantial exclusion, barring nonspecific binding, to tissues not possessing these sites thereby providing the desired increase in contrast in the NMR image produced.

It should be noted, however, that in order to obtain sufficient reorientation flexibility, it may be preferable to employ only a portion of the antibody, such as the F(ab)' portion so that the $Mn^{++}$ macromolecule complex will maintain tissue specificity but also have freedom to spin or rotate about a single axis. The F(ab)' portion, as is well-known, provides only "one arm" of reactive binding site and does not include the Fc portion or the "other arm". Methods for its derivation are well-known in the art.

Similar effects may be accomplished by employing the so-called hybrid antibodies, or those having specificity for two different antigenic sites. By careful selection of the specificities, given information regarding the proximity of corresponding antigenic binding sites, one may ensure the antibody binds at only one site thereby effectively permitting relatively unhindered motion of the $Mn^{++}$ macromolecule complex. As will be now readily apparent, by choosing the antibody specificity for a designated infectious agent or cancer type, the reagent formed by coupling the $Mn^{++}$ paramagnetic ion to the antibody will provide a reagent capable of enhancing the contrast between normal and infected or cancerous tissue, respectively, in nuclear magnetic resonance imaging.

As may be now appreciated and in accordance with the objects of this invention and the theoretical considerations set forth herein, this preferred

embodiment, the attachment of an antibody, or piece thereof, to a paramagnetic ion such as $Mn^{++}$ results in a more effective agent for $T_1$ relaxation effects, provides a reagent which is less toxic as compared with free $Mn^{++}$ ions or $Mn^{++}$ hydrates, and, provides highly advantageous tissue specificity.

The macromolecule, however, need not be an antibody or derived therefrom but may be any one of a great number of biological molecules which serve as enzyme substrates. Such a complex will ideally have the paramagnetic ion attached to the substrate at a location which does not substantially interfere with the activity of the enzyme upon the substrate. Preferably, the enzymatic reaction will be one which, by altering the size of the substrate - $Mn^{++}$ as compared to the product - $Mn^{++}$, will change the effect of the manganese complex upon the relaxation rates to an extent sufficient to enhance contrast. Judicious selection of the appropriate enzymatic system to accomplish this may require some simple experimentation. Consequently, the presence or activity of the enzyme in some tissue will result in contrast enhancement against surrounding tissue which lacks such enzyme activity. Accordingly, such a reagent would be useful in viability studies where nonviable cells may be expected to have a paucity of active enzymes as well as for several diagnostic applications.

As another example of the versatility of the present invention, the paramagnetic ion may be coupled to adenine triphosphate (ATP), a high energy molecule found within most cells. Energy is released when phosphorous is removed and ADP formed. This change in size of the macromolecule, i.e., the loss of one phosphorous molecule, although smaller than ideally desired, may be sufficient to detect differences in image contrast. Thus, such a

system may also serve to enhance contrast between viable and nonviable or active from less active tissues.

The instant invention may additionally be employed to test clearance rates or kidney function. It is known that urine has a $T_1$ of approximately more than one second so that the appearance of $Mn^{++}$, particularly as an effective $T_1$ relaxation agent, will be dramatic. As may be readily appreciated, kidney function would ideally be tested by attaching an inert macromolecule of the appropriate size (see later discussion) to a paramagnetic ion and injecting it into the blood stream. The macromolecule is preferably chosen to be inert so as to avoid being metabolized by the liver or other tissues which would thereby serve to dilute the concentration within the blood stream and prevent the material from being cleared by the kidneys and imaged in the bladder. Following injection, the patient's bladder may be scanned such as by the Technicare Teslacon NMR Imaging System (available from Technicare, Solon, Ohio) with virtually any field strength such as 1.5, 3 or 5 kilogauss and the resultant images recorded over time. This instrument may, of course, be used with any of the examples provided herein.

Still other possible macromolecules suggest themselves and include liposomes as a targeting vehicle for enhancing the contrast in NMR images of the liver, spleen or kidney. The liposomes may either contain the paramagnetic ion bound to another macromolecule or may themselves be bound to the paramagnetic ion, providing the liposomes possess the necessary weight characteristics. Still other useful macromolecules include those molecules which may normally be present in cell membranes or other cellular organelles.

Still another embodiment provides for the attachment of $Mn^{++}$ or other paramagnetic ion to either DNA or, to the so-called DNA probes such as those available from Enzo-Biochem Inc. (New York, NY). Again, assuming appropriate weight considerations be given to the choice of the macromolecule (to advantageously adjust the $T_1$ relaxation times), one may employ such a reagent as a contrast agent to help discriminate between DNA 'active' and 'nonactive' or less active tissues in NMR imaging. Such DNA activity may serve as a clinically useful detection tool for identifying nonviable, ischemic, infected or even cancerous tissues.

As has been previously intimated, the macromolecule is chosen so that it is effective in bringing the paramagnetic ion's correlation time within an order of magnitude of the Larmor period of the target atom whose resonance is being measured. This effectiveness will be related, at least to some extent, to the macromolecule's molecular weight, typically measured in daltons. Such a theoretical relationship is shown in Figure 5.

Using the 'primitive' Stoke-Einstein model of fluid dynamics, the rotational correlation time of the ion-macromolecule complex can be estimated as a function of the molecular weight of the macromolecule ligands. Thereafter, the $T_1$ and $T_2$ may be calculated as a function of the macromolecule's molecular weight according to the Solomon-Bloembergen-Morgan theory. By using equation (5), $T_1$ and $T_2$ of the system can be evauated for a given concentration of the $Mn^{++}$ ion. Assuming that $T_{1B}$ = $T_{2B}$ = 3.5 seconds, such a calculation is presented graphically in Figure 5 for a $Mn^{++}$ concentration of 10 μm and at proton NMR frequencies of 6, 25 and 60 MHz which correspond to field strengths of 0.15, 0.6 and 1.5 tesla.

The values used to formulate Figure 5 are given below in Table I.

TABLE I

$T_1$ and $T_2/T_1$ as a Function of Mol. Wt. of Ligand Macromolecule

| | 6MHz | | 25MHz | | 60MHz | |
|---|---|---|---|---|---|---|
| Mol. Wt. | $T_1$ | $T_2/T_1$ | $T_1$ | $T_2/T_1$ | $T_1$ | $T_2/T_1$ |
| 18 | 3.20 | .72 | 3.20 | .72 | 3.32 | .714 |
| 1K | 1.38 | .79 | 1.43 | .79 | 1.44 | .785 |
| 5K | .546 | .83 | .557 | .82 | .606 | .780 |
| 10K | .381 | .84 | .399 | .82 | .479 | .728 |
| 25K | .274 | .84 | .299 | .80 | .422 | .639 |
| 50K | .236 | .84 | .267 | .78 | .414 | .586 |
| 75K | .213 | .84 | .256 | .78 | .413 | .564 |
| 100K | .214 | .84 | .251 | .77 | .413 | .552 |
| 250K | .205 | .84 | .242 | .76 | .414 | .530 |
| 500K | .201 | .84 | .239 | .76 | .415 | .522 |
| $10^6$ | .200 | .84 | .237 | .76 | .415 | .518 |

where $T_1$ is in seconds and $K = 10^3$.

Normally, the $T_2/T_1$ reflects the signal strength and therefore the molecular weight is preferably chosen to maximize this, i.e. higher on the curves. On the other hand $T_1$ is chosen to be short, i.e. lower on the $T_1$ curves, to enhance the complex's effectiveness. If a maximum "distance" is chosen between curves, this may be expected to provide a range of preferred molecular weights. Naturally, this range may shift depending upon the accuracy of the model chosen, the concentration of

the $Mn^{++}$ used, and the NMR frequency. Significant decreases in $Mn^{++}$ concentration will permit $T_1$ and $T_2$ to become longer thereby yielding a weaker signal while a significant concentration increase can be expected to change the $T_1/T_2$ ratio as $T_2$ becomes too short thereby also resulting in a weaker signal. Clearly, those skilled will recognize that based on the relatively flat curves shown in Figure 5, i.e. broad ranges, some experimentation may be necessary to derive the ideal concentration in each particular instance.

As may be readily understood, depending on the type of macromolecule selected, and indeed the paramagnetic ion selected, various chemical schemes may be necessary in order to effect the linking therebetween. As may be readily appreciated, this may involve the use of accessory linking agents such as those described in various aforecited chelating references. The extent and manner with which such schemes may need to be modified is matter well within the knowledge of those skilled in the art.

Although $Mn^{++}$ is, due to its somewhat unique properties regarding long correlation times for the scalar interaction ($\tau_S$) and other characteristic NMR time constants, the generally preferred paramagnetic ion, other paramagnetic ions are equally contemplated and include for instance appropriate forms of chromium, iron, copper and gadolinium.

It will, of course, be appreciated that the reagents of the present invention may be used in any of the known NMR imaging methods in conjunction with any available machine designed for carrying out such methods in a clinical environment.

Although numerous possible embodiments have been described above, the spirit and scope of the present invention should not be limited thereto but shall also include those substitutions and alterations which will be readily appreciated by those skilled in the art.

CLAIMS

1. A reagent for altering the nuclear magnetic resonance relaxation rate of a target atom associated with a specific tissue comprising a paramagnetic ion attached to a macromolecule selected in accordance with its ability, based on molecular weight, to cause the correlation time of the paramagnetic ion to be within an order of magnitude of the Larmor period of the target atom.

2. The reagent of claim 1, wherein the macromolecule is tissue specific or viability specific.

3. The reagent of claim 2, wherein the macromolecule is an antibody or is derived therefrom.

4. The reagent of claim 3, wherein the macromolecule is the F(ab)' portion of an antibody.

5. The reagent of claim 2, wherein the macromolecule is a lipsome, enzyme, enzyme substrate, ATP, nucleic acid, nucleic acid probes, cell membrane component or molecule reactive therewith, or cellular organelle component.

6. The reagent of claim 5, wherein the macromolecule is a substrate for an enzyme associated with a subset of a set of cells, the paramagnetic ion is attached to the macromolecule in such a way that the function of the macromolecule as an enzyme substrate is not substantially impeded, and the macromolecule, when acted on by the enzyme, forms a product containing the paramagnetic ion, which, in the product, has the required correlation time.

7. The reagent of any one of claims 1 to 6, wherein the correlation time is from $10^{-1}$ to $10^{+1}$ times the Larmor period of the $^1H$ atom.

8. The reagent of any one of claims 1 to 7, wherein the paramagnetic ion is a transition metal ion having partially filled3d or 4d orbitals.

9. The reagent of claim 8, wherein the transition metal is manganese, gadolinium, chromium, iron or copper.

10. The reagent of claim 9, wherein the transition metal is manganese.

11. The reagent of any one of claims 1 to 10 for use in enhancing nuclear magnetic resonance images of biological tissue.

12. The reagent of claim 2 or any claim dependent thereon for use in enhancing contrast in a nuclear magnetic resonance image between tissue for which the macromolecule is specific and tissue for which it is not specific.

13. The reagent of claim 6 or any claim dependent thereon for use in enhancing contrast in a nuclear magnetic resonance image between areas of enzyme activity and areas of lesser enzyme activity.

14. Use of the reagent of any one of claims 1 to 10 in enhancing nuclear magnetic resonance images of biological tissue.

15. Use of the reagent of claim 2 or any claim dependent thereon in enhancing contrast in a nuclear magnetic resonance image between tissue for which the macromolecule is specific and tissue for which it is not specific.

16. Use of the reagent of claim 6 or any claim dependent thereon in enhancing contrast in a nuclear magnetic resonance image between areas of enzyme activity and areas of lesser enzyme activity.

FIG. 1

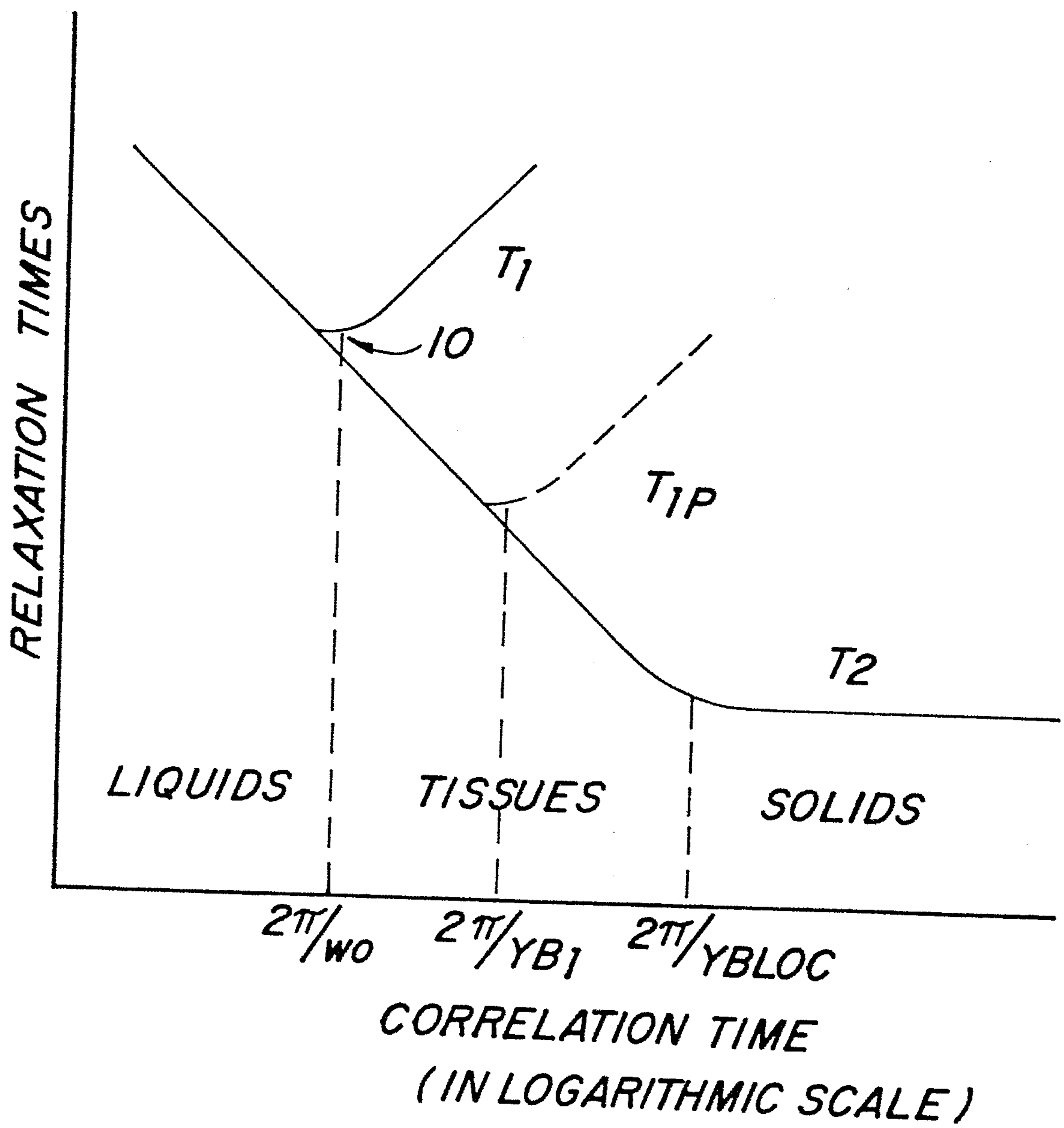
RELAXATION TIMES
T1
10
T1P
T2
LIQUIDS
TISSUES
SOLIDS
2π/WO
2π/YB1
2π/YBLOC
CORRELATION TIME
(IN LOGARITHMIC SCALE)

FIG. 2

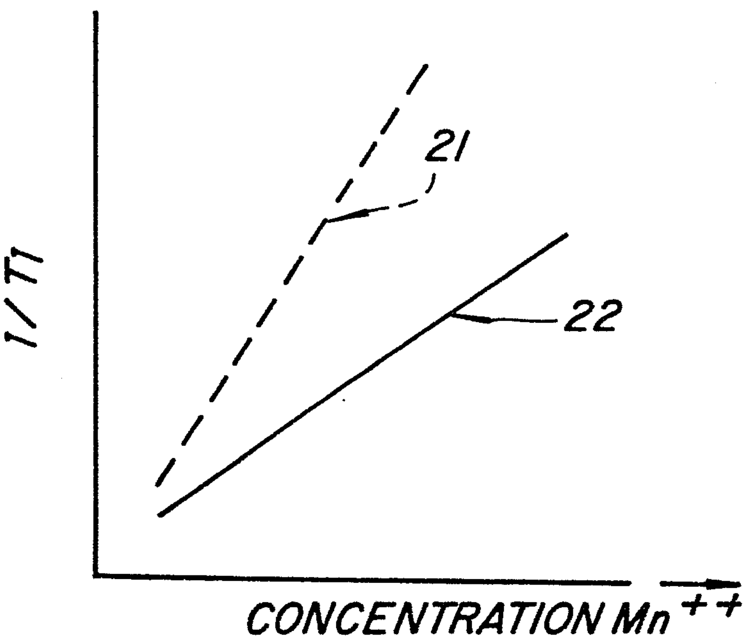
1/T1
21
22
CONCENTRATION Mn++

FIG. 3

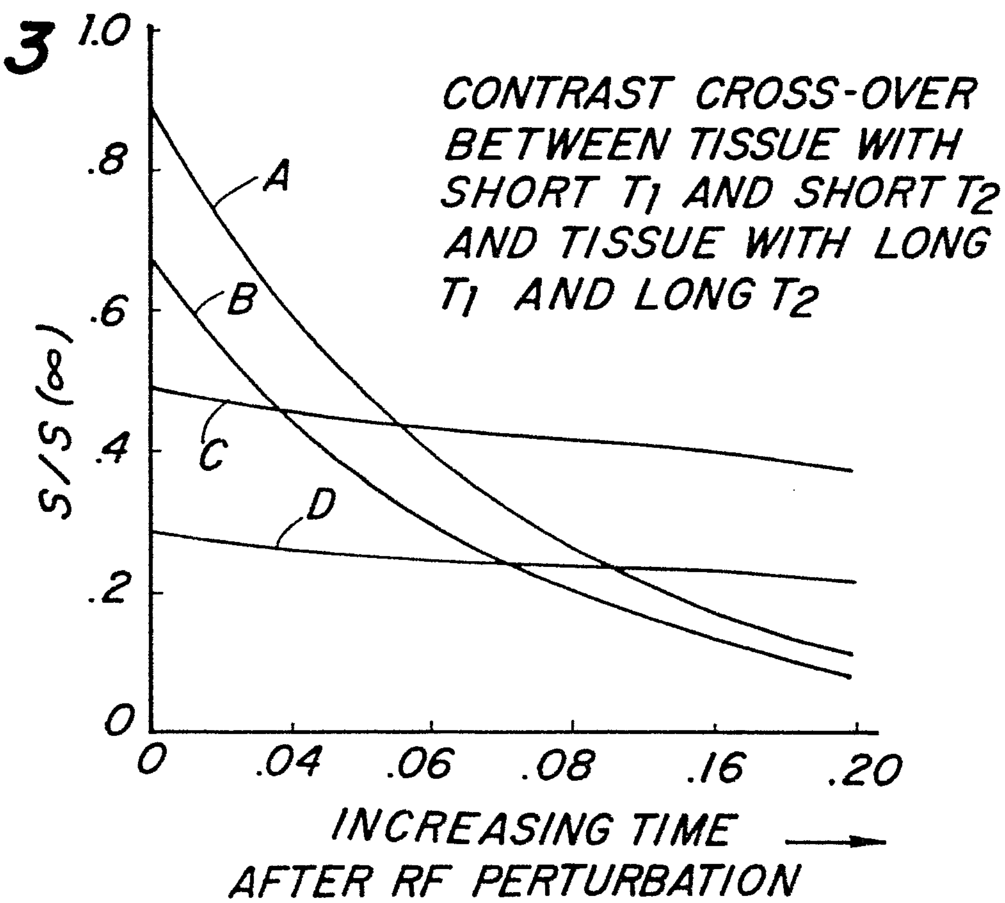
1.0
.8
.6
.4
.2
0
S/S (∞)
A
B
C
D
CONTRAST CROSS-OVER
BETWEEN TISSUE WITH
SHORT T1 AND SHORT T2
AND TISSUE WITH LONG
T1 AND LONG T2
0
.04
.06
.08
.16
.20
INCREASING TIME
AFTER RF PERTURBATION

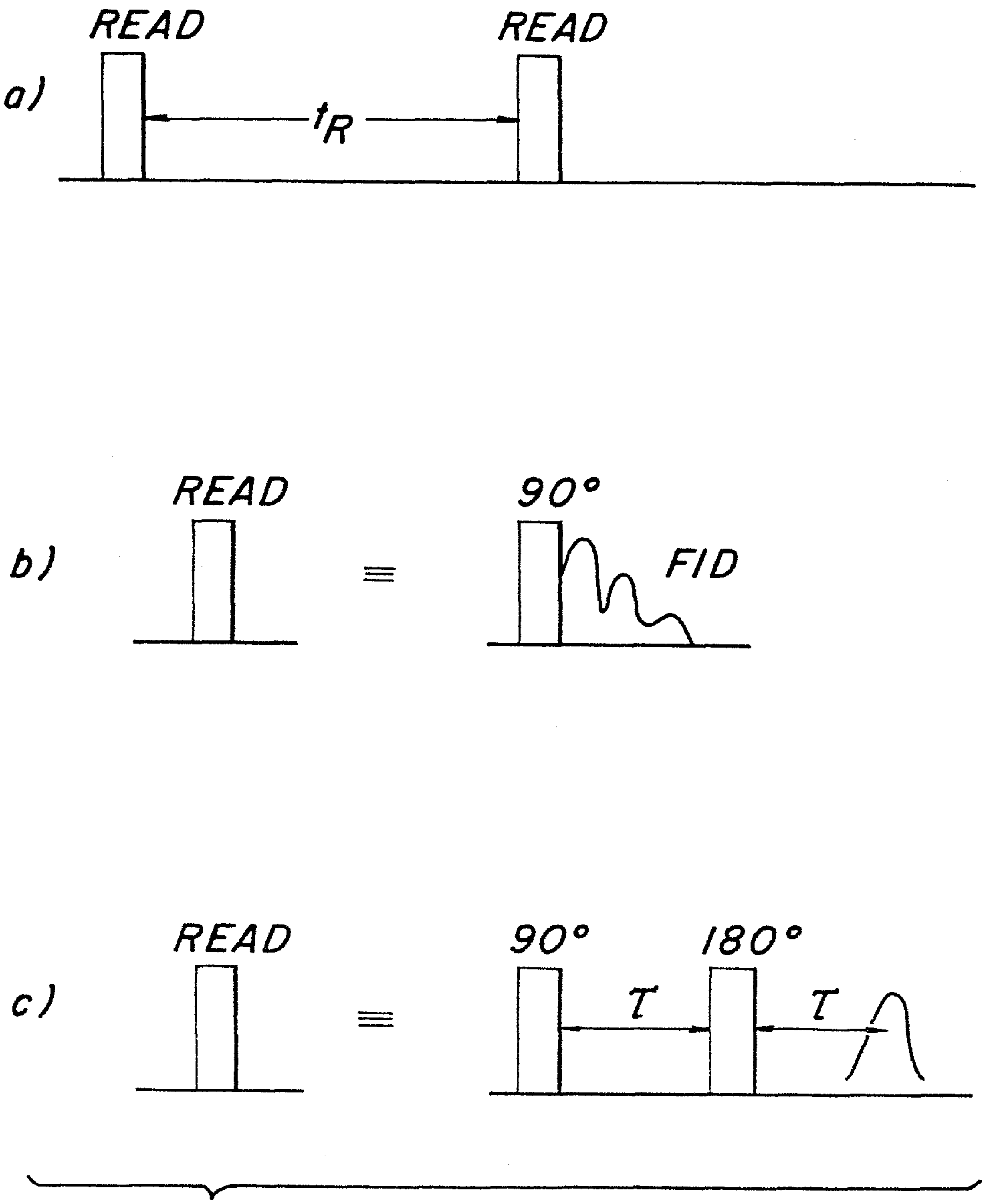


FIG. 4

SATURATION RECOVERY
RADIO FREQUENCY PULSE
SEQUENCE IN NMR IMAGING

FIG. 5

T1 AND T2/T1 AS A FUNCTION OF MOL. WT. OF LIGAND MACROMOLECULES OVER FREQUENCIES OF 6,25 AND 60MHz

$[Mn^{++}] = 10 \mu M$

$T_s = 3 \times 10^{-9}$ SEC.